# EUROPÄISCHE PATENTSCHRIFT

(11) **EP 3 643 147 B1**
(45) Veröffentlichungstag und Bekanntmachung des Hinweises auf die Patenterteilung: **03.07.2024**
(21) Anmeldenummer: 18718455.1
(22) Anmeldetag: 18.04.2018
(51) Int. Cl.: H05K 1/18, H01L 23/00, H05K 3/30, H05K 3/32, H05K 3/28

(54) **ELEKTRONIKMODUL**
ELECTRONIC MODULE
MODULE ÉLECTRONIQUE

(30) Priorität: 19.06.2017 DE 102017210176
(43) Veröffentlichungstag der Anmeldung: 29.04.2020
(73) Patentinhaber: Robert Bosch GmbH, 70442 Stuttgart (DE)
(72) Erfinder: BRAUN, Holger, 70435 Stuttgart (DE); SCAFFIDI, Sandro, 73092 Heiningen (DE); WEISS, Markus, 73760 Ostfildern (DE)
(86) Internationale Anmeldenummer: PCT/EP2018/059860
(87) Internationale Veröffentlichungsnummer: WO 2018/233899

(56) Entgegenhaltungen:
- EP-A2- 0 103 255
- EP-A2- 1 734 800
- EP-B1- 1 459 611
- DE-A1- 19 706 790
- DE-A1-102007 002 323
- US-A1- 2010 248 505
- US-A1- 2011 221 654
- US-A1- 2017 094 796

## Beschreibung

### Stand der Technik

Bekannte Elektronikmodule sind mit einer elektronischen Steuerschaltung mit signalverarbeitenden elektrischen Bauelementen und Leistungsbauelementen sowie mit Sensoren und Steckerteilen versehen. Die Elektronikmodule können auch als Getriebesteuermodule in einem Kraftfahrzeug verbaut werden und sind dort dem Hydrauliköl des Kraftfahrzeuggetriebes und Temperaturen zwischen -40 °C und 150 °C ausgesetzt. In letzter Zeit sind Elektronikmodule entwickelt worden, die eine Schutzmasse verwenden, welche die Bauelemente auf der Leiterplatte abdeckt. Da Stecker und Sensoren auch mit Komponenten außerhalb des Elektronikmoduls kontaktiert werden, müssen diese außerhalb der Schutzmasse angeordnet werden oder aus der Schutzmasse herausragen.

Aus der DE 10 2015 214 311 A1 ist ein Elektronikmodul bekannt, das eine Leiterplatte als Schaltungsträger aufweist. An einer Bestückungsseite der Leiterplatte ist wenigstens ein erstes Bauelement angeordnet und mit dieser elektrisch kontaktiert. Ein Kontaktelement, das eine erste Oberfläche und eine von der ersten Oberfläche abgewandte zweite Oberfläche aufweist, ist mit der ersten Oberfläche an der Leiterplatte angeordnet und mit dieser elektrisch kontaktiert. Eine Schutzmasse, die an der Bestückungsseite der Leiterplatte angeordnet ist, kapselt das erste Bauelement ein, wobei auch das Kontaktelement teilweise in die Schutzmasse derart eingebettet ist, dass seitliche Flanken des Kontaktelementes wenigstens teilweise von der Schutzmasse umlaufend bedeckt sind, während die zweite Oberfläche des Kontaktelementes freiliegend aus der Schutzmasse herausragt. Ein als Sensorelement vorgesehenes zweites Bauelement ist an dem Kontaktelement befestigt und über dieses mit der Leiterplatte elektrisch verbunden. Das zweite Bauelement weist wenigstens einen elektrischen Anschlussleiter auf, der in eine Kunststoffumhüllung eingebettet ist und einen Anschlussabschnitt aufweist, der parallel zu der zweiten Oberfläche des Kontaktelementes ausgerichtet ist und mit dem Kontaktelement elektrisch verbunden ist. Das zweite Bauelement bildet quasi einen Sensordom der an dem Kontaktelement festgelegt wird. Das Kontaktelement weist in der DE 10 2015 214 311 A1 einen Grundkörper aus Kunststoff auf, in den elektrische Leiter eingebettet sind.

DE102007002323 A1 handelt es sich um ein Elektronikmodul, dessen Leiterplatte elektronische Bauelemente enthält und bei Kontaktelementen mit anderen Modulen elektrisch verbunden ist.

US 2017094796 ist ein elektronisches Modul. Es setzt sich aus einer eingebetteten Leiterplatte mit elektronischen Komponenten und einem Kontaktelement zusammen, dessen Terminals über das eingebettete Material hinausgehen. In dieser Situation befindet sich eine Leiterplatte, die das Kontaktelement mit dem elektronischen Modul verknüpft.

US2010248505 schließt ein elektronisches Modul mit eingebettetem PCB ab und beinhaltet einen Kontakt zum Anschluss an ein externes Modul (Display).

### Offenbarung der Erfindung

Die Erfindung betrifft eine Elektronikmodul mit den Merkmalen der Oberbegriffs des Anspruchs 1. Erfindungsgemäß weist die Kunststoffumhüllung des zweiten Bauelementes an ihrer der Leiterplatte zugewandten Seite eine erste Aussparung auf, durch welche der Anschlussabschnitt oder ein mit dem Anschlussabschnitt verbundener Kontaktkörper des zweiten Bauelementes zugänglich ist. Das Kontaktelement ist in die erste Aussparung derart eingeführt, dass die zweite Oberfläche des Kontaktelementes an dem Anschlussabschnitt oder an dem mit dem Anschlussabschnitt verbundenen Kontaktkörper flächig anliegt.

### Vorteile der Erfindung

Durch die Erfindung wird vorteilhaft erreicht, dass das zweite Bauelement mittels einer einfachen und kostengünstigen Verbindungstechnik mit der Leiterplatte kontaktiert werden kann. Besonders vorteilhaft hierbei ist, dass durch eine stabile mechanische Verbindung zwischen dem zweiten Bauelement und der Leiterplatte gleichzeitig eine elektrische Verbindung hergestellt wird. Durch die Einführung des Kontaktelementes in die erste Aussparung der Kunststoffumhüllung erfolgt eine einfache Ausrichtung des zweiten Bauelementes relativ zur Leiterplatte.

Dadurch, dass die zweite Oberfläche des Kontaktelementes an einem Anschlussabschnitt oder an einem mit dem Anschlussabschnitt verbundenen Kontaktkörper flächig anliegt, wird eine feste elektrische und mechanische Verbindung zwischen diesen Komponenten ermöglicht, welche beispielsweise mittels Schraubverbindungen oder durch Laserschweißen in einfacher Weise hergestellt werden können. Da hierzu nur wenige Elemente benötigt werden, können Fertigungstoleranzen minimiert werden.

Das zweite Bauelemente kann einteilig sein und vorteilhaft erst nach der Aufbringung und Aushärtung der Schutzmasse auf die Leiterplatte aufgebacht werden. Dadurch wird es vorteilhaft möglich, dass das Elektronikmodul nach der Auftragung der Schutzmasse zunächst relativ flach aufgebaut ist und in einer automatisierten Fertigungsanlage besser verarbeitet werden kann. Die zweiten Bauelemente, welche beispielsweise als Sensordome ausgebildet sind, und von dem Elektronikmodul stärker herausragen, können vorteilhaft erst nach der Auftragung der Schutzmasse an dem Elektronikmodul befestigt werden.

Durch die Minimierung der Anzahl an Kontaktstellen wird ein zuverlässiger Betrieb des Elektronikmoduls erreicht. Durch die Einführung des Kontaktelementes in die Aussparung der Kunststoffumhüllung wird die Stabilität und Belastbarkeit der elektrischen Verbindungstelle verbessert, so dass diese einen höheren Widerstand gegenüber Vibrations- und Schüttelbelastungen aufweist. Außerdem kann ein aggressive Fluid die Kontaktstelle nicht umspülen, so dass schädliche Ablagerungen wie Metallspäne von der Kontaktstelle ferngehalten werden.

Vorteilhafte Ausgestaltungen und Weiterbildungen der Erfindung werden durch die in den abhängigen Ansprüchen enthaltenen Merkmale ermöglicht.

Dadurch, dass die seitlichen Flanken des Kontaktelements mit geringer Spielpassung zu der Kunststoffumhüllung in die Aussparung eingeführt sind, wird vorteilhaft erreicht, dass die Lagetoleranzen des zweiten Bauelementes relativ zur Leiterplatte in einer zu der Leiterplatte parallelen Ebene minimiert werden. Außerdem wird der Spalt zwischen der Innenwandung der Aussparung und den seitlichen Flanken des Kontaktelementes stark verkleinert, so dass sich dort keine Metallspäne ablagern können, die beispielsweise in einem Getriebefluid enthalten sein können.

Besonders vorteilhaft ist es, wenn die Kunststoffumhüllung des zweiten Bauelementes auf ihrer von der Leiterplatte abgewandten Seite eine zweite Aussparung aufweist, durch welche der Anschlussabschnitt oder ein mit dem Anschlussabschnitt verbundener Kontaktkörper des zweiten Bauelementes zugänglich ist. Idealer Weise befindet sich diese zweite Aussparung auf der von ersten Seite gegenüberliegenden Seite des Anschlussabschnitts oder des mit dem Anschlussabschnitts verbundenen Kontaktkörpers. Die zweite Aussparung dient als Montageöffnung zur Einführung von beispielsweise schraubbaren Befestigungsmittel oder als Beleuchtungsöffnung zur Einstrahlung eines Laserstrahls.

Vorteilhaft ist das Kontaktelement aus Metall und beispielsweise als Gewindebuchse oder als Sockelteil ausgebildet ist. Das heißt das Kontaktelement ist massiv aus Metall gebildet und nicht wie im Stand der Technik als mit Kunststoff umspritztes Stanzgitterteil. Daher kann eine stabile mechanische Befestigung gleichzeitig mit der Herstellung der elektrischen Verbindung durch den Einsatz von schraubbaren Befestigungsmitteln oder durch Laserschweißen erfolgen.

Das zweite Bauelement kann wenigstens zwei elektrische Anschlussleiter aufweisen, die jeweils mit einem zugeordneten Kontaktelement elektrisch verbunden sind. Da zwei Kontaktelemente mit Abstand zueinander auf der Leiterplatte montiert sein können, wird durch die Befestigung des zweiten Bauelements an zwei zueinander beabstandeten Kontaktelementen eine noch stabilere und genauere Ausrichtung des zweiten Bauelementes auf der Leiterplatte möglich.

Vorteilhaft kann die Kunststoffumhüllung des zweiten Bauelementes eine Grundplatte aufweisen, von der ein Vorsprung auf der von der Leiterplatte abweisenden Seite abragt. Der wenigstens eine elektrische Anschlussleiter kann in dem Vorsprung senkrecht zu der Leiterplatte angeordnet sein, wobei der Anschlussabschnitt des elektrischen Anschlussleiters in der Grundplatte parallel zu der Leiterplatte verlaufend angeordnet ist. Dadurch wird erreicht, dass der parallel zu der Leiterplatte verlaufende Anschlussabschnitt in einfacher Weise an der zweiten Oberfläche des Kontaktelementes flächig zur Anlage gelangen kann. Die Grundplatte ermöglicht eine einfach und zugleich stabile Montage oberhalb der Schutzmasse der Leiterplatte.

Obwohl prinzipiell zahlreiche Möglichkeiten bestehen, das zweite Bauelement an dem Kontaktelement zu befestigen, ist es besonders vorteilhaft, wenn das Kontaktelement als Gewindebuchse ausgebildet ist und das zweite Bauelement mittels schraubbarer Befestigungsmittel an der Gewindebuchse festgelegt ist. In einem andern Ausführungsbeispiel ist vorgesehen, dass das Kontaktelement als Sockelteil ausgebildet ist und das zweite Bauelement durch eine Laserschweißverbindung zwischen dem Anschlussabschnitt und dem Sockelteil an dem Sockelteil festgelegt ist.

Vorteilhaft kann die zweite Aussparung auf der von der Leiterplatte abgewandten Seite der Kunststoffumhüllung von einem Kragen umgeben sein. Der Kragen kann als Spanschutz fungieren. Zudem kann an dem Kragen eine Abdeckkappe befestigt werden, welche die zweite Aussparung abdeckt. Falls eine Schraube als Befestigungsmittel eingesetzt wird, kann die Kappe verdrehsicher an der Kunststoffumhüllung des zweiten Bauelementes befestigt werden und als Arretierungsmittel in die Schraube derart eingreifen, dass sich die Schraube nicht lösen kann.

### Kurze Beschreibung der Zeichnungen

Fig. 1 zeigt einen Querschnitt durch ein erstes Ausführungsbeispiel eines erfindungsgemäßen Elektronikmoduls,
Fig. 2 zeigt einen Teilquerschnitt durch ein zweites Ausführungsbeispiel eines erfindungsgemäßen Elektronikmoduls,
Fig. 3 zeigt einen Querschnitt durch ein drittes Ausführungsbeispiel eines erfindungsgemäßen Elektronikmoduls,
Fig. 4 zeigt einen Teilquerschnitt durch ein viertes Ausführungsbeispiel eines erfindungsgemäßen Elektronikmoduls.

### Ausführungsformen der Erfindung

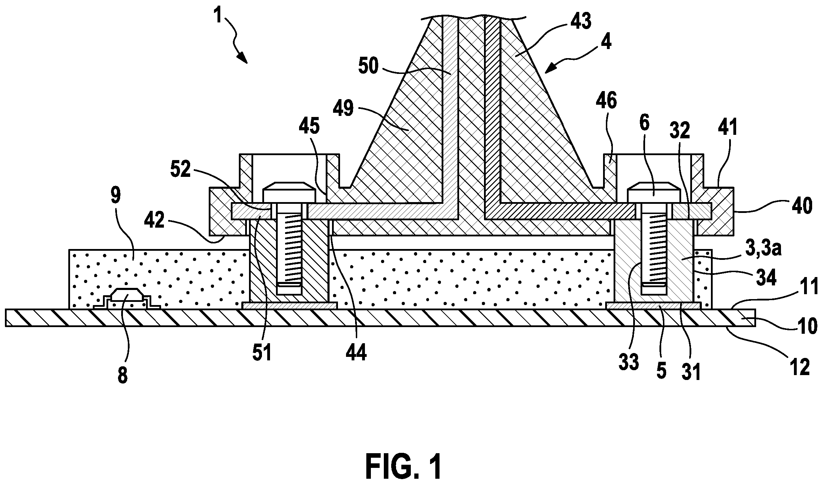

Fig. 1 zeigt einen Querschnitt durch ein Elektronikmodul 1. Das Elektronikmodul kann beispielsweise Teil einer Getriebesteuereinrichtung eines Kraftfahrzeuges sein und dem Hydraulikfluid des Getriebes ausgesetzt sein. Es ist aber auch möglich, das Elektronikmodul als Steuergerät zur Ansteuerung eines anderen Aggregats einzusetzen. Das Elektronikmodul 1 weist eine Leiterplatte 10 mit einer als Bestückungsseite 11 vorgesehenen ersten Seite und einer davon abgewandten zweiten Seite 12 auf. Die Leiterplatte 10 kann beispielsweise als glasfaserverstärktem Epoxidharzsubstrat ausgebildet sein, beispielsweise als FR4-Leiterplatte oder höherwertig. Auf der Bestückungsseite 11 der Leiterplatte 10 sind elektrische Bauelemente einer Steuerschaltung angeordnet, von denen in Fig. 1 nur ein erstes Bauelement 8 dargestellt ist. Das erste Bauelement 8 kann über nicht dargestellte Leiterbahnen der Leiterplatte 10 mit einer auf der Bestückungsseite 11 der Leiterplatte angeordneten Kontaktfläche 5 elektrisch verbunden sein.

Auf der Bestückungsseite 11 der Leiterplatte 10 ist eine Schutzmasse 9 angeordnet, die das erste Bauelement 8 einkapselt. Die Schutzmasse kann eine polymere Schutzmasse, insbesondere ein Duroplast und ganz insbesondere ein Epoxidharz umfassen, das gut auf der Leiterplatte 10 haftet.

Ein Kontaktelement 3 ist auf die Kontaktfläche 5 aufgesetzt. Das Kontaktelement 3 besteht aus Metall und weist eine erste Oberfläche 31 und eine von der ersten Oberfläche abgewandte zweite Oberfläche 32 und seitliche Flanken 34 auf. Die Schutzmasse 9 bedeckt die seitlichen Flanken 34 des Kontaktelementes 3 umlaufend. Allerdings ragt das Kontaktelement 3 mit der zweiten Oberfläche 32 und mit dem an diese angrenzenden Teil der seitlichen Flanken 34 aus der Schutzmasse 9 heraus.

Das Kontaktelement 3 ist mit der ersten Oberfläche 31 an der Kontaktfläche 5 der Leiterplatte 10 verlötet oder verschweißt. In dem Ausführungsbeispiel der Fig. 1 ist das Kontaktelement 5 als Gewindebuchse 3a ausgebildet. Eine Gewindeöffnung 33 erstreckt sich ausgehend von der zweiten Oberfläche 32 in das Innere der Gewindebuchse 3a.

In Fig. 1 sind zwei Kontaktelemente 4 dargestellt, die auf die Leiterplatte 10 bestückt sind. Es aber auch möglich, dass nur ein einzelnes Kontaktelement oder drei oder mehr Kontaktelemente 3 auf der Leiterplatte bestückt werden. Wie man weiterhin in Fig. 1 erkennen kann, ist ein zweites Bauelement 4 beispielsweise an zwei Kontaktelementen 5 befestigt. Das zweite Bauelement 4 kann aber auch an nur einem oder mehr als zwei Kontaktelementen 5 befestigt sein.

Das zweite Bauelement 4 kann beispielsweise ein Sensor, insbesondere ein Drehzahlsensor, oder ein elektrisches Verbindungsteil oder ein anderes elektrisches Bauteil sein. Das zweite Bauelement 4 weist wenigstens einen elektrischen Anschlussleiter 50 auf, der in eine Kunststoffumhüllung 49 eingebracht ist. Es kann sich beispielsweise um ein Spritzgussteil handeln. In Fig. 1 weist das zweite Bauelement zwei Anschlussleiter 50 auf. Die Kunststoffumhüllung 49 des zweiten Bauelementes 4 kann eine Grundplatte 40 aufweisen, von der ein Vorsprung 43 auf der von der Leiterplatte 10 abweisenden Seite 41 abragt. In Fig. 1 ist nur ein Teil des Vorsprungs 43 erkennbar. Am Endabschnitt des Vorsprungs 43 kann beispielsweise ein in der Kunststoffumhüllung verkapseltes Sensorelement oder ein Steckanschluss vorgesehen sein. Die elektrischen Anschlussleiter 50 sind in dem Vorsprung 43 senkrecht zu der Leiterplatte 10 angeordnet. Jeweils ein Anschlussabschnitt 51 ist rechtwinklig umgebogen, so dass er parallel zu der Leiterplatte 10 verläuft. Die beiden Anschlussabschnitt 51 sind entgegengesetzt zueinander abgebogen und in eine Grundplatte 40 der Kunststoffumhüllung 49 eingebettet. Die Grundplatte 40 weist eine erste Seite 42 auf, die der Leiterplatte 10 zugewandt ist und eine zweite Seite 41, die von der Leiterplatte 10 abgewandt ist.

Die Kunststoffumhüllung 49 des zweiten Bauelementes 4 weist an der ersten Seite 42 erste Aussparungen 44 aufweist, durch welche die Anschlussabschnitte 51 des zweiten Bauelementes 4 zugänglich sind. Die Aussparungen 44 können beispielsweise Sacklochartig sein. Am Grund jeder Aussparung 44 befindet sich der jeweilige Anschlussabschnitt 51, beziehungsweise der Anschlussabschnitt 51 liegt dort frei.

Die Kontaktelemente 3 sind mit der zweiten Oberfläche 32 in die Aussparungen 44 soweit eingeführt, dass die zweite Oberfläche 32 flächig an einer der Leiterplatte zugewandten Fläche der Anschlussabschnitte 51 zur Anlage gelangt. Auf der gegenüberliegenden Seite der Anschlussabschnitte 51 weist die Kunststoffumhüllung 49 zweite Aussparungen 45 auf, welche als Montageöffnungen zum Einsetzen von Schrauben 6 dienen. Der Rand der zweiten Aussparung 45 kann von einem Kragen 46 umgeben sein. Wie in Fig. 1 erkennbar ist, ist jeweils eine Schraube 6 von der zweiten Aussparung 45 aus, durch ein Durchgangsloch 52 eines zugeordneten Anschlussabschnitts 51 in die Gewindeöffnung 33 des als Gewindebuchse 3a ausgebildeten Kontaktelementes 3 eingeschraubt. Beim Anziehen der Schraube 6 presst der Schraubenkopf den Anschlussabschnitt 51 flächig an die zweite Oberfläche 32 der Gewindebuchse 3a, so dass eine feste mechanische und elektrische Verbindung entsteht. Ein Restspalt zwischen der ersten Seite 42 der Kunststoffumhüllung 49 und der Schutzmasse 9 kann gegebenenfalls mit Klebstoff, beispielsweise einem Underfiller ausgefüllt, wobei dieser für einer Anwendung im Getriebefluid resistent gegenüber Hydraulikfluid sein sollte.

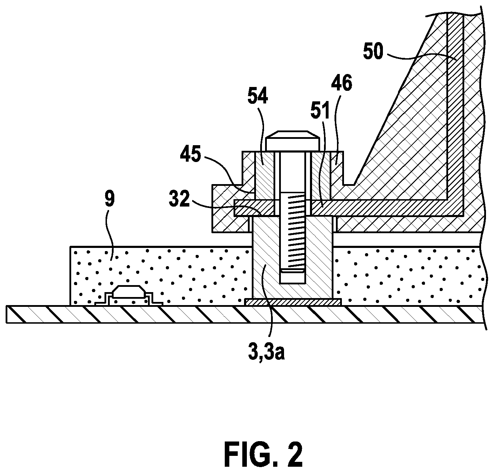

Fig. 2 zeigt einen Teilquerschnitt durch ein zweites Ausführungsbeispiel eines erfindungsgemäßen Elektronikmoduls. Im Folgenden wird nur noch auf diejenigen Teile Bezug genommen, die anders als in Fig. 1 ausgebildet sind. Im Unterschied zu Fig. 1 ist bei diesem Ausführungsbeispiel eine Metallhülse 54 in einen Kragen 46 eingesetzt, welcher die zweite Aussparung 45 umläuft. Die Metallhülse 54 liegt an dem Anschlussabschnitt 51 an und erstreckt sich von dort aus bis zum oberen Rand der Kragens 46. Der Schraubenkopf der Schraube 6 stützt sich in diesem Ausführungsbeispiel an der Metallhülse 54 ab und beaufschlagt dadurch den Anschlussabschnitt 51 zwischen der Metallhülse 54 und der Gewindebuchse 3b mit einer Spannkraft. Der Schraubenkopf der Schraube 6 kann die Innenausnehmung der Metallhülse 54 und damit die zweite Aussparung 45 gegenüber dem Außenraum vorteilhaft verkapseln.

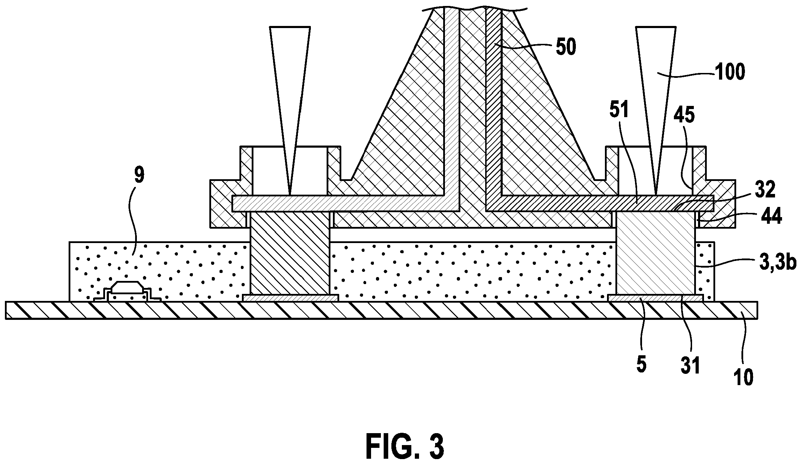

Ein drittes Ausführungsbeispiel des erfindungsgemäßen Elektronikmoduls 1 ist in Fig. 3 dargestellt. In Fig. 3 ist sind die Kontaktelemente 3 als massive Sockelteile 3b aus Metall ausgebildet. Die Anschlussabschnitte 51 liegen flächig an der zweiten Oberfläche 32 der Kontaktelemente 3 an. Die zweite Aussparung 45 auf der den Kontaktelementen 3 gegenüberliegenden Seite der Anschlussabschnitte 51 dient als Beleuchtungsöffnung für einen Laserstrahl 100. Der Laserstrahl 100 wird durch die zweite Aussparung 45 hindurch auf die Anschlussabschnitte 51 gerichtet, schmilzt diese und die darunter liegende zweite Oberfläche 32 der Kontaktelemente auf und verschweißt dadurch die Anschlussabschnitte 51 mit den Kontaktelementen 3, beziehungsweise den Sockelteilen 3b. Auch hier entsteht eine mechanische stabile Verbindung, welche zugleich der elektrischen Kontaktierung dient.

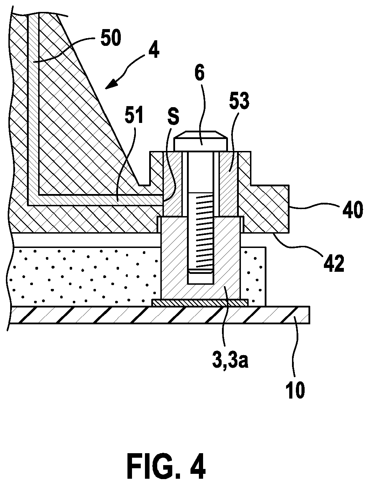

Ein viertes Ausführungsbeispiel ist in Fig. 4 gezeigt. Bei diesem Ausführungsbeispiel ist ein mit dem Anschlussabschnitt 51 verbundener Kontaktkörper 53 in die Kunststoffumhüllung 49 des zweiten Bauelementes 4 eingebettet. Der Kontaktkörper 53 ist als Metallhülse ausgebildet. Im Unterscheid zu dem Ausführungsbeispiel von Fig. 2 endet in diesem Ausführungsbeispiel der Anschlussabschnitt 51 endseitig an dem Kontaktkörper 53 und ist an einer Anbindungsstelle S mit dem Kontaktkörper 53 beispielsweise verschweißt. Auch in diesem Ausführungsbeispiel ist das Kontaktelement 3 als Gewindebuchse 3a ausgebildet, die in eine erste Aussparung 44 auf einer der Leiterplatte 10 zugewandten Seite 42 eingeführt wird. Allerdings gelangt die zweite Oberfläche 32 des Kontaktelementes 3 in diesem Ausführungsbeispiel an dem mit dem Anschlussabschnitt 51 verbundenen hülsenförmigen Kontaktkörper 53 flächig zur Anlage. Eine in den hülsenförmigen Kontaktkörper 53 und die Gewindebuchse 3b eingeschraubte Schraube 6 presst den Kontaktkörper 53 gegen die zweite Oberfläche 32 der Gewindebuchse 3b, so dass auch hier ein zuverlässige mechanische und elektrische Verbindung entsteht.

## Patentansprüche

1. Elektronikmodul (1), aufweisend:
eine Leiterplatte (10),
ein erstes Bauelement (8), welches an einer Bestückungsseite (11) der Leiterplatte (10) angeordnet und mit dieser elektrisch kontaktiert ist,
ein Kontaktelement (3), das eine erste Oberfläche (31) und eine von der ersten Oberfläche (31) abgewandte zweite Oberfläche (32) aufweist und das mit der ersten Oberfläche (31) an der Leiterplatte (10) angeordnet und mit dieser elektrisch kontaktiert ist,
eine Schutzmasse (9), die an der Bestückungsseite (11) der Leiterplatte (10) angeordnet ist und die das erste Bauelement (8) einkapselt, wobei das Kontaktelement (3) teilweise in die Schutzmasse (9) derart eingebettet ist, dass seitliche Flanken (34) des Kontaktelementes (3) wenigstens teilweise von der Schutzmasse (9) umlaufend bedeckt sind und die zweite Oberfläche (32) des Kontaktelementes (3) freiliegend aus der Schutzmasse (9) herausragt,
ein zweites Bauelement (4), welches an dem Kontaktelement (3) befestigt ist und über dieses mit der Leiterplatte (10) elektrisch verbunden ist, wobei das zweite Bauelement (4) wenigstens einen elektrischen Anschlussleiter (50) aufweist, der in eine Kunststoffumhüllung (49) eingebettet ist und einen Anschlussabschnitt (51) aufweist, der parallel zu der zweiten Oberfläche (32) des Kontaktelementes (3) ausgerichtet ist und mit dem Kontaktelement (3) elektrisch verbunden ist, wobei die zweite Oberfläche (32) des Kontaktelementes (3) an dem Anschlussabschnitt (51) oder an einem mit dem Anschlussabschnitt (51) verbundenen Kontaktkörper (53) flächig anliegt,
**dadurch gekennzeichnet, dass**
die Kunststoffumhüllung (49) des zweiten Bauelementes (4) an ihrer der Leiterplatte (10) zugewandten Seite (42) eine erste Aussparung (44) aufweist, durch welche der Anschlussabschnitt (51) oder der mit dem Anschlussabschnitt (51) verbundene Kontaktkörper (53) des zweiten Bauelementes (4) zugänglich ist, und dass die Kunststoffumhüllung (49) des zweiten Bauelementes (4) auf ihrer von der Leiterplatte (10) abgewandten Seite (41) eine zweite Aussparung (45) aufweist, durch welche der Anschlussabschnitt (51) oder der mit dem Anschlussabschnitt (51) verbundener Kontaktkörper (53) des zweiten Bauelementes (4) zugänglich ist.

2. Elektronikmodul nach Anspruch 1, **dadurch gekennzeichnet, dass** die seitlichen Flanken (34) des Kontaktelements (3) mit geringer Spielpassung zu der Kunststoffumhüllung (49) in die Aussparung (44) eingeführt sind.

3. Elektronikmodul nach Anspruch 1, **dadurch gekennzeichnet, dass** das Kontaktelement (3) aus Metall und als Gewindebuchse (3a) oder als Sockelteil (3b) ausgebildet ist.

4. Elektronikmodul nach einem der vorstehenden Ansprüche, **dadurch gekennzeichnet, dass** das zweite Bauelement (4) wenigstens zwei elektrische Anschlussleiter (50) aufweist, die jeweils mit einem zugeordneten Kontaktelement (3) elektrisch verbunden sind.

5. Elektronikmodul nach einem der vorstehenden Ansprüche, **dadurch gekennzeichnet, dass** die Kunststoffumhüllung (49) des zweiten Bauelementes (4) eine Grundplatte (40) aufweist, von der ein Vorsprung (43) auf der von der Leiterplatte (10) abweisenden Seite (41) abragt, und dass der elektrische Anschlussleiter (50) in dem Vorsprung (43) senkrecht zu der Leiterplatte (10) angeordnet ist und der Anschlussabschnitt (51) in der Grundplatte (40) parallel zu der Leiterplatte (10) verlaufend angeordnet ist.

6. Elektronikmodul nach Anspruch 3, **dadurch gekennzeichnet, dass** das Kontaktelement (3) als Gewindebuchse ausgebildet und das zweite Bauelement (4) mittels schraubbarer Befestigungsmittel (6) an der Gewindebuchse (3a) festgelegt ist.

7. Elektronikmodul nach Anspruch 3, **dadurch gekennzeichnet, dass** das Kontaktelement (3) als Sockelteil (3b) ausgebildet ist und dass das zweite Bauelement (4) durch eine Laserschweißverbindung zwischen dem Anschlussabschnitt (51) und dem Sockelteil (3b) an dem Sockelteil (3b) festgelegt ist.

8. Elektronikmodul nach Anspruch 1, **dadurch gekennzeichnet, dass** die zweite Aussparung (45) auf der von der Leiterplatte (10) abgewandten Seite (41) der Kunststoffumhüllung (49) von einem Kragen (46) umgeben ist.

9. Elektronikmodul nach einem der vorstehenden Ansprüche, **dadurch gekennzeichnet, dass** das Elektronikmodul (1) Teil einer Getriebesteuereinrichtung eines Kraftfahrzeuges ist.

## Claims

1. Electronics module (1), comprising:
a printed circuit board (10),
a first component (8), which is arranged on a component side (11) of the printed circuit board (10) and electrically contact-connected thereto,
a contact element (3), which has a first surface (31) and a second surface (32) averted from the first surface (31) and which, by way of the first surface (31), is arranged on the printed circuit board (10) and electrically contact-connected thereto,
a protective compound (9), which is arranged on the component side (11) of the printed circuit board (10) and which encapsulates the first component (8), wherein the contact element (3) is partially embedded in the protective compound (9) in such a way that lateral flanks (34) of the contact element (3) are at least partially circumferentially covered by the protective compound (9) and the second surface (32) of the contact element (3) protrudes from the protective compound (9) such that it is exposed,
a second component (4), which is fastened to the contact element (3) and is electrically connected to the printed circuit board (10) via this second component, wherein the second component (4) has at least one electrical connection conductor (50), which is embedded in a plastics sheathing (49) and has a connection portion (51) which is oriented parallel to the second surface (32) of the contact element (3) and is electrically connected to the contact element (3), wherein the second surface (32) of the contact element (3) rests flat against the connection portion (51) or against a contact body (53) connected to the connection portion (51),
**characterized in that**
the plastics sheathing (49) of the second component (4) has a first cutout (44) on its side (42) facing the printed circuit board (10), through which cutout the connection portion (51) or the contact body (53) of the second component (4) connected to the connection portion (51) is accessible, and **in that** the plastics sheathing (49) of the second component (4) has a second cutout (45) on its side (41) averted from the printed circuit board (10), through which cutout the connection portion (51) or the contact body (53) of the second component (4) connected to the connection portion (51) is accessible.

2. Electronics module according to Claim 1, **characterized in that** the lateral flanks (34) of the contact element (3) are inserted into the cutout (44) with a small clearance fit with respect to the plastics sheathing (49).

3. Electronics module according to Claim 1, **characterized in that** the contact element (3) is formed from metal and as a threaded bushing (3a) or as a base part (3b).

4. Electronics module according to any of the preceding claims, **characterized in that** the second component (4) has at least two electrical connection conductors (50) which are each electrically connected to an associated contact element (3).

5. Electronics module according to any of the preceding claims, **characterized in that** the plastics sheathing (49) of the second component (4) has a base plate (40) from which a projection (43) protrudes on the side (41) facing away from the printed circuit board (10), and **in that** the electrical connection conductor (50) is arranged in the projection (43) perpendicularly to the printed circuit board (10) and the connection portion (51) is arranged in the base plate (40) in a manner running parallel to the printed circuit board (10).

6. Electronics module according to Claim 3, **characterized in that** the contact element (3) is designed as a threaded bushing and the second component (4) is fixed to the threaded bushing (3a) using screwable fastening means (6).

7. Electronics module according to Claim 3, **characterized in that** the contact element (3) is designed as a base part (3b) and **in that** the second component (4) is fixed to the base part (3b) by a laser welding connection between the connection portion (51) and the base part (3b).

8. Electronics module according to Claim 1, **characterized in that** the second cutout (45) is surrounded by a collar (46) on the side (41) of the plastics sheathing (49) averted from the printed circuit board (10).

9. Electronics module according to any of the preceding claims, **characterized in that** the electronics module (1) is part of a gearbox control device of a motor vehicle.

## Revendications

1. Module électronique (1), présentant :
une carte de circuits imprimés (10),
un premier composant (8) qui est disposé sur une face d'implantation (11) de la carte de circuits imprimés (10) et est mis en contact électrique avec celle-ci,
un élément de contact (3) qui présente une première surface (31) et une deuxième surface (32) détournée de la première surface (31), et qui est disposé par la première surface (31) au niveau de la carte de circuits imprimés (10) et est mis en contact électrique avec celle-ci,
une masse de protection (9) qui est disposée sur la face d'implantation (11) de la carte de circuits imprimés (10) et qui encapsule le premier composant (8), dans lequel l'élément de contact (3) est partiellement incorporé dans la masse de protection (9) de telle sorte que des flancs latéraux (34) de l'élément de contact (3) sont au moins partiellement recouverts en périphérie par la masse de protection (9), et la deuxième surface (32) de l'élément de contact (3) dépasse de la masse de protection (9) en étant exposé,
un deuxième composant (4) qui est fixé à l'élément de contact (3) et est relié électriquement à la carte de circuits imprimés (10) par l'intermédiaire de celui-ci, dans lequel le deuxième composant (4) présente au moins un conducteur de raccordement électrique (50) qui est incorporé dans une gaine en matière plastique (49) et présente une section de raccordement (51) qui est orientée en parallèle à la deuxième surface (32) de l'élément de contact (3) et est reliée électriquement à l'élément de contact (3), dans lequel la deuxième surface (32) de l'élément de contact (3) est adjacente de manière plane à la section de raccordement (51) ou à un corps de contact (53) relié à la section de raccordement (51),
**caractérisé en ce que**
la gaine en matière plastique (49) du deuxième composant (4) présente sur sa face (42) tournée vers la carte de circuits imprimés (10) un premier évidement (44) par lequel la section de raccordement (51) ou le corps de contact (53) relié à la section de raccordement (51) du deuxième composant (4) est accessible, et **en ce que** la gaine en matière plastique (49) du deuxième composant (4) présente sur sa face (41) détournée de la carte de circuits imprimés (10) un deuxième évidement (45) par lequel la section de raccordement (51) ou le corps de contact (53) relié à la section de raccordement (51) du deuxième composant (4) est accessible.

2. Module électronique selon la revendication 1, **caractérisé en ce que** les flancs latéraux (34) de l'élément de contact (3) sont introduits dans l'évidement (44) avec un ajustement à jeu réduit par rapport à la gaine en matière plastique (49).

3. Module électronique selon la revendication 1, **caractérisé en ce que** l'élément de contact (3) est réalisé en métal et sous forme de douille filetée (3a) ou de pièce formant socle (3b).

4. Module électronique selon l'une quelconque des revendications précédentes, **caractérisé en ce que** le deuxième composant (4) présente au moins deux conducteurs de raccordement électriques (50) qui sont respectivement reliés électriquement à un élément de contact associé (3) .

5. Module électronique selon l'une quelconque des revendications précédentes, **caractérisé en ce que** la gaine en matière plastique (49) du deuxième composant (4) présente une plaque de base (40) à partir de laquelle une saillie (43) dépasse de la face (41) détournée de la carte de circuits imprimés (10), et **en ce que** le conducteur de raccordement électrique (50) est disposé dans la saillie (43) perpendiculairement à la carte de circuits imprimés (10), et la section de raccordement (51) est disposée dans la plaque de base (40) en s'étendant en parallèle à la carte de circuits imprimés (10) .

6. Module électronique selon la revendication 3, **caractérisé en ce que** l'élément de contact (3) est réalisé sous forme de douille filetée et le deuxième composant (4) est immobilisé au niveau de la douille filetée (3a) à l'aide de moyens de fixation (6) pouvant être vissés.

7. Module électronique selon la revendication 3, **caractérisé en ce que** l'élément de contact (3) est réalisé sous forme de pièce formant socle (3b), et **en ce que** le deuxième composant (4) est immobilisé au niveau de la pièce formant socle (3b) par un assemblage soudé au laser entre la section de raccordement (51) et la pièce formant socle (3b).

8. Module électronique selon la revendication 1, **caractérisé en ce que** le deuxième évidement (45) est entouré d'une collerette (46) sur la face (41) détournée de la carte de circuits imprimés (10) de la gaine en matière plastique (49).

9. Module électronique selon l'une quelconque des revendications précédentes, **caractérisé en ce que** le module électronique (1) fait partie d'un dispositif de commande de transmission d'un véhicule automobile.
